# EUROPEAN PATENT APPLICATION

(11) **EP 4 621 418 A1**
(43) Date of publication of application: **24.09.2025**
(21) Application number: 24164895.5
(22) Date of filing: 20.03.2024
(51) Int. Cl.: G01R 13/02, H04B 17/345, G01R 23/16

(54) **METHOD AND MONITORING SYSTEM FOR MONITORING A SIGNAL WITH INHERENT PERIODIC CHARACTERISTICS**

(71) Applicant: Rohde & Schwarz GmbH & Co. KG, 81671 München (DE)
(72) Inventor: He, Jun, Singapore 486041 (SG); Wang, James, Singapore 486041 (SG); Sun, JianHua, Singapore 486041 (SG)
(74) Representative: Prinz & Partner mbB

(57) **Abstract**

A method of monitoring a signal with inherent periodic characteristics. A monitoring time period for the signal is set. A trace of the signal is measured continuously within the monitoring time period based on an internal clock. A signal portion of interest is identified in the trace. A length and an offset to a start point of the monitoring time period for a monitoring window are defined such that the monitoring window is aligned with the signal portion of interest. At least one reference mark is identified in the trace. A drift of the reference mark is detected while monitoring the signal. It is determined whether the drift detected exceeds a threshold value. The monitoring window is adjusted in case the drift detected exceeds the threshold value. Further, a monitoring system (10) is described.

## Description

The invention relates to a method of monitoring a signal with inherent periodic characteristics. Further, the invention relates to a monitoring system for monitoring a signal with inherent periodic characteristics.

In modern telecommunication technologies, duplexing techniques have become of importance, particularly time-division duplexing (TDD) as well as frequency-division duplexing (FDD). Time-division duplexing (TDD) is the application of time-division multiplexing to separate outward and return signals. Actually, full-duplex communication is emulated over a half-duplex communication link. Frequency-division duplexing (FDD) means that the transmitter and receiver operate using different carrier frequencies.

Time-division duplexing is a versatile and efficient duplexing technology that offers several advantages over frequency-division duplexing, as the spectrum is used more efficiently, thereby providing more flexible allocation of resources at lower costs. Consequently, time-division duplexing has been adopted by multiple communication standards, including LTE-TDD, Wi-Fi and 5G.

Since 5G becomes relevant for several different application scenarios, TDD networks become ubiquitous such that detecting an interferer of a TDD network becomes a critical task to ensure smooth operation of the respective TDD network. Actually, the detection of the interferer may comprise identifying and locating the interferer.

In general, time synchronization is a crucial issue of TDD networks. Accordingly, it is necessary that a monitoring instrument is able to lock to a given time-slot of the periodic frame structure of the TDD network for a long time without drift in order to be enabled to inter alia detect an interferer. In the state of the art, this time synchronization is achieved by either locking the time of the monitoring device to a highly accurate time source like a global navigation satellite system (GNSS) time source or by being part of the TDD network while decoding physical layer signals within the TDD network.

However, the approaches known in the state of the art have limitations, as GNSS is not always available, for instance in indoor environments like factories that employ 5G networks. Furthermore, it is not feasible to support all current and future TDD technologies by a given monitoring device.

Accordingly, there is a need for a method and a system that ensure monitoring of signals with inherent periodic characteristics like TDD signals in a reliable and cost-efficient manner.

The invention provides a method of monitoring a signal with inherent periodic characteristics, for instance a TDD signal. The method comprises the steps of:
- Setting a monitoring time period for the signal,
- Measuring a trace of the signal continuously within the monitoring time period based on an internal clock,
- Identifying a signal portion of interest in the trace,
- Defining an offset to a start point of the monitoring time period and a length for a monitoring window such that the monitoring window is aligned with the signal portion of interest,
- Identifying at least one reference mark in the trace,
- Detecting a drift of the reference mark identified while monitoring the signal,
- Determining whether the drift detected exceeds a threshold value, and
- Adjusting the monitoring window in case the drift detected exceeds the threshold value.

Further, the invention provides a monitoring system for monitoring a signal with inherent periodic characteristics. The monitoring system comprises an input configured to receive the signal. The monitoring system further comprises at least one processing circuit that is connected with the input. The at least one processing circuit is configured to continuously measure a trace of the signal received within a monitoring time period based on an internal clock. The at least one processing circuit is further configured to define an offset to a start point of the monitoring time period and a length for a monitoring window such that the monitoring window is aligned with a signal portion of interest in the trace. The at least one processing circuit is also configured to detect a drift of a reference mark identified while monitoring the signal. Moreover, the at least one processing circuit is configured to determine whether the drift detected exceeds a threshold value. The at least one processing circuit is also configured to adjust the monitoring window in case the drift detected exceeds the threshold value.

Therein and in the following, the term "circuit" is generally understood to denote suitable hardware, suitable software, a combination of hardware and software being configured to perform the described functionality.

The hardware may, inter alia, comprise a CPU, a GPU, an FPGA, an ASIC, or other types of electronic circuitry.

The invention is based on the idea to provide a method and a monitoring system that monitor and track signals with inherent periodic characteristics, for instance time-division duplex, TDD, signals without time synchronization. In other words, it is not necessary to synchronize to a highly accurate time source like a GNSS time source or even to be part of the communication network, for instance a TDD network, to decode physical layer signals for time synchronization.

In contrast to the state of the art, the invention relies purely on the internal clock. In fact, the monitoring system can be employed by a monitoring instrument, namely a single device. Thus, the monitoring instrument has a housing that encompasses the at least one processing circuit which is enabled to perform the respective steps mentioned above, e.g. by means of sub-circuits like a measuring sub-circuit and/or a trace generation sub-circuit. Alternatively, the monitoring system, particularly the monitoring instrument, comprises several processing circuits that are enabled to perform the respective steps mentioned above, for instance a measuring circuit and/or a trace generation circuit. As indicated above, the monitoring system, particularly the monitoring instrument, comprises the internal clock that does not have to be synchronized to a network clock and/or a global clock like a GNSS clock.

Consequently, the trace of the signal to be monitored, namely the signal with the inherent periodic characteristics, is captured/measured with a local time reference, namely an internal time reference provided by the internal clock. As indicated above, the respective capturing/measuring of the trace is done without decoding the signal to be monitored or rather accessing a highly accurate time source like a GNSS time source.

In contrast to performing the respective time synchronization as it was done in the state of the art, the invention relies on detecting and tracking the position of at least one reference mark, for instance one specific inherent periodic characteristic of the signal to be monitored. The at least one reference mark identified in the trace is continuously monitored in order to detect a potential drift of the reference mark while monitoring the signal with the inherent periodic characteristics. In case a drift of the reference mark is detected, it is still possible to keep the monitoring window with the signal portion of interest in synchronization, namely by adjusting the monitoring window accordingly, e.g. shifting the monitoring window with the drift detected.

In general, the subject matter of the invention does not rely on accessing to highly accurate time sources like GNSS time sources. In addition, the subject matter of the invention is open to new application scenarios, particularly for factories that are deployed with a 5G network where indoor accessing GNSS is not available. Moreover, the subject matter of the invention does not rely on decoding a physical layer of the communication.

Since the subject matter of the invention relies on the internal clock instead of highly accurate time sources like GNSS time sources, the subject matter of the invention can be implemented on any monitoring system that supports measuring/capturing the trace of the signal with local time reference.

The respective trace may relate to a video trace, as the samples gathered, particularly the amplitudes thereof, are put in relation to time, namely an internal time reference obtained by the internal clock.

An aspect provides that the monitoring window is adjusted by changing the offset to the start point of the monitoring time period and/or the length of the monitoring window. The at least one processing circuit may be configured to adjust the monitoring window by changing the offset and/or the length of the monitoring window. Accordingly, the monitoring window is shifted with regard to its position, namely by changing the offset to the start point of the monitoring time period, and/or shaped by adapting its length accordingly. Therefore, it is ensured that the monitoring window is adapted with respect to the signal portion of interest in the trace once the drift of the reference mark is detected. Put differently, it is assumed that the signal portion of interest drifts in a similar manner as the reference mark does such that the monitoring window is adjusted with respect to the drift detected in order to ensure that the monitoring window is adapted with the assumed drift of the signal portion of interest.

Therefore, a temporal synchronization of the monitoring window and the signal to be monitored can be ensured even though no explicit time synchronization is obtained between the signal to be monitored and the monitoring system, particularly the clock time (of the measurement system) and a network time and/or a global time.

Accordingly, the monitoring window may be adjusted such that the monitoring window is aligned again with the signal portion of interest in the trace even though the drift occurred. As indicated above, it is assumed that the signal portion of interest and the reference mark drift in a similar manner. The drift is detected for the reference mark, thereby assuming that the signal portion of interest drifts in a similar manner. Based on the drift detected for the reference mark, the monitoring window is adjusted so as to compensate for the drift. Consequently, the monitoring window is adjusted such that it is still aligned with the signal portion of interest in the trace.

Another aspect provides that information about the adjusted monitoring window is forwarded to an output interface. The monitoring system may comprise an output interface via which information about the adjusted monitoring window is outputted. The output interface may be an external output interface of the monitoring system or an internal output interface of the monitoring system, for instance an internal output interface of the monitoring instrument. The information about the adjusted monitoring window may be distributed, for instance internally within the monitoring instrument, such that other (processing) circuits or external devices may use the information. For instance, the information may be distributed to an analysis circuit, for instance a fast Fourier transform (FFT) circuit configured to perform a FFT.

According to a further aspect, the monitoring time period may be adjusted. In case of a high drift detected, particularly a high drift rate, the monitoring time period may be adjusted. In other words, the drift may be high such that the signal portion of interest is not located in the monitoring time period at least completely. By adjusting the monitoring time period, the monitoring time period may be shifted or rather enlarged such that the signal portion of interest is located (again) in the monitoring time period. Consequently, the monitoring window can be applied so as to match the signal portion of interest.

The monitoring time period may be set to match a frame structure of the signal, for instance 10 ms for a 5G TDD signal. This ensures that the whole frame of the signal to be monitored is considered such that the trace encompasses at least one frame of the signal to be monitored. Generally, the frame may be segmented into sub-frames, for instance ten sub-frames of a length of 1 ms for a 5G TDD signal.

The reference mark may be identified manually by a user. The user may interact with the monitoring system in order to select the reference mark within the trace, for instance selecting a certain portion of the trace as reference mark.

For instance, the reference mark is identified by setting the reference mark in the trace via a graphical user interface, for instance a touchscreen on which the trace is displayed. Therefore, the user is enabled to easily identify the reference mark to be used while interacting with the graphical user interface.

Generally, the monitoring system may comprise a user interface via which a user is enabled to set the monitoring time period, to identify the signal portion of interest in the trace, and/or to identify the at least one reference mark in the trace. The respective input(s) of the user are/is forwarded to the at least one processing circuit that processes the input(s) accordingly, namely for continuously measuring the trace of the signal, defining the length and the offset to the start point of the monitoring time period for the monitoring window, for detecting the drift of the reference mark, for determining whether the drift detected exceeds the threshold value, and/or for adjusting the monitoring window in case the drift detected exceeds the threshold value.

Alternatively or additionally, the reference mark may be identified automatically by scanning the signal and detecting a repeated appearance of a transition in the signal. The at least one processing circuit may be configured to automatically identify the at least one reference mark in the trace based on a repeated appearance of a transition in the signal. Thus, the reference mark may be associated with a certain transition of the signal, for instance a high-to-low appearance or rather a low-to-high appearance. In fact, the respective transition takes place in a repetitive manner such that it can be detected automatically. For instance, the transition may relate to a synchronization signal blog (SSB) of the signal. The respective transition may have a fixed offset to the start of the monitoring time period set, namely the frame structure of the signal to which the monitoring time period may be matched.

Generally, the at least one reference mark may relate to a characteristic of the signal. As mentioned above, the at least one reference mark can be a high-to-low or a low-to-high signal portion of the signal with the inherent periodic characteristics, wherein one of the inherent periodic characteristics is used for the reference mark accordingly, as it appears in a periodic manner, e.g. in each frame.

Hence, the steps of setting the monitoring time period for the signal, identifying a signal portion of interest in the trace, and/or identifying at least one reference mark in the trace may be done via the (graphical) user interface, e.g. the (graphical) user interface of the measurement system, particularly the measurement instrument. Alternatively, at least one of these steps may be performed by the at least one processing circuit, e.g. the step of identifying a signal portion of interest in the trace, and/or the step of identifying at least one reference mark in the trace. The step of setting the monitoring time period for the signal may be done automatically, e.g. by selecting a certain type of signal to be monitored, as the monitoring time period is set to match the frame structure of the signal to be monitored.

The steps of measuring a trace, defining the length and the offset, detecting the drift, determining whether the drift exceeds the threshold value, and/or adjusting the monitoring windows may however be performed by the at least one processing circuit, e.g. the at least one processing circuit of the measurement system, particularly the measurement instrument.

In general, the position of at least one inherent periodic characteristic of the signal to be monitored, namely the at least one reference mark, is detected and tracked within a defined monitoring time period. This ensures to keep the position of the monitoring window with the signal portion of interest in synchronization, namely to keep alignment of the monitoring window and the signal portion of interest, e.g. by adjusting the monitoring window and, optionally, by adjusting the monitoring time period. In other words, the monitoring system is kept in synchronization with a transmitter of the signal to be monitored without relying on a global time source like a GNSS time source and without physical layer decoding. In addition, information about the adjusted monitoring window can be distributed for further analysis of signal to be monitored, particularly the signal portion of interest. The information may be distributed to other modules and/or circuits in the measurement system, particularly the measurement instrument.

Further aspects and advantages of the claimed subject matter will become more readily appreciated as the same become better understood by reference to the following description when taken in conjunction with the accompanying drawings. In the drawings,
- Figure 1 schematically shows an embodiment of the monitoring system according to the invention,
- Figure 2 schematically shows a flow-chart illustrating the method of monitoring a signal with periodic characteristics according to an exemplarily embodiment of the invention,
- Figure 3 shows a diagram illustrating the concept of the method according to the invention,
- Figure 4 shows a diagram illustrating the consequences in case a drift occurs and the method according to the invention is not applied, and
- Figure 5 shows the diagram of Figure 4 in case the method according to the invention is applied.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

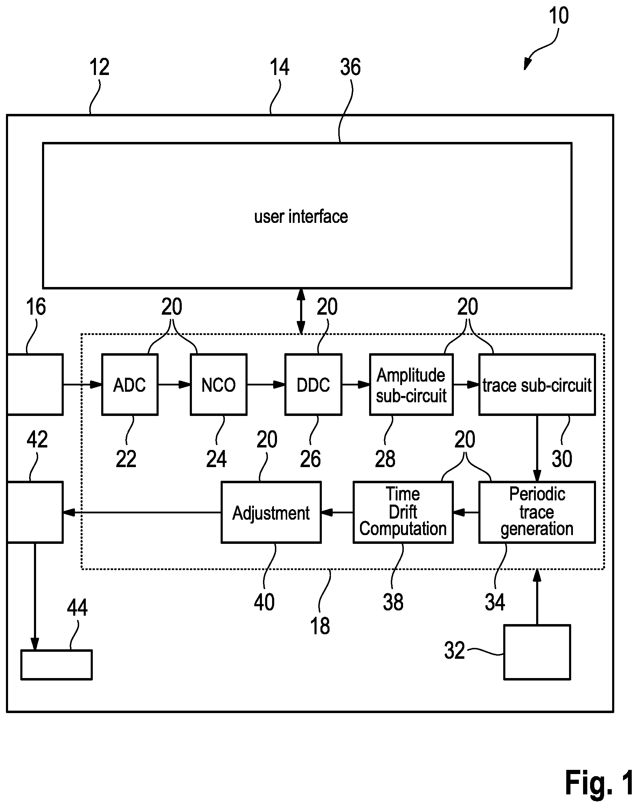

In Figure 1, a monitoring system 10 for monitoring a signal with inherent periodic characteristics is shown.

In the shown embodiment, the monitoring system 10 is realized by a monitoring instrument 12, namely a single device, which comprises a housing 14.

The monitoring system 10 has an input 16 that is configured to receive the signal with the inherent periodic characteristics. The input 16 is located at least partly at an outer side of the housing 14 such that the input 16 is accessible.

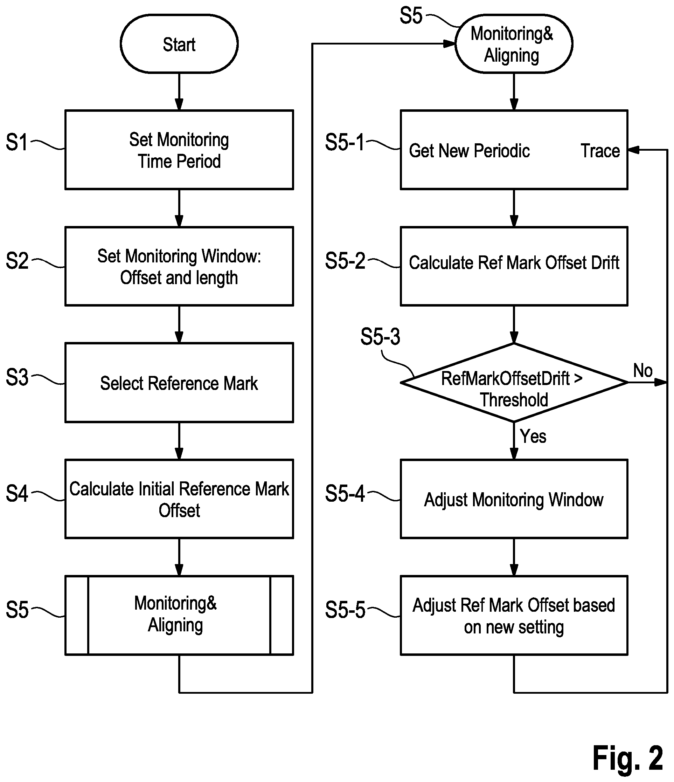

The housing 14 further encompasses at least one processing circuit 18 that is connected with the input 16 and configured to perform certain steps described later with reference to Figures 2 to 5 in more detail.

In Figure 1, the at least one processing circuit 18 is illustrated in detail, as respective sub-circuits 20 are shown. Instead of several sub-circuits 20, the monitoring system 10 may also comprise several processing circuits 18.

In the shown embodiment, the monitoring system 10 comprises an analog to digital converter 22, ADC, that is used to convert the analog signal received by the input 16, namely the signal with the inherent periodic characteristics, into a digital format, for instance digital samples. In fact, a digitized signal is generated by the analog to digital converter 22 for further processing.

The monitoring system 10 further comprises a numerically controlled oscillator 24, NCO, that is connected with the analog to digital converter 22. The numerically controlled oscillator 24 is tuned to the frequency of the signal with the inherent periodic characteristics.

In addition, the monitoring system 10 has a digital down converter 26, DDC, that is connected with the numerically controlled oscillator 24. The digital down converter 26 is configured to filter and down-sample the digitized signal to an appropriate bandwidth for further processing. In fact, the digital down converter 26 outputs a down-sampled digitized signal.

The monitoring system 10 also comprises an amplitude sub-circuit 28 that is configured to compute an amplitude of the down-sampled digitized signal, namely the IQ samples, received from the digital down converter 26.

Further, the monitoring system 10 has a trace sub-circuit 30 that is configured to generate a trace over time, namely the amplitude of the IQ samples of a local time provided by an internal clock 32.

In addition, a periodic trace generation sub-circuit 34 is provided that is configured to segment the trace obtained from the trace sub-circuit 30 into fixed lengths based on parameters/settings as discussed later in more detail when referring to Figures 2 to 6.

For instance, the parameters/settings are defined by a user of the monitoring system 10, for instance via a user interface 36, particularly a graphical user interface, GUI.

Further, the monitoring system 10 has a time drift computation sub-circuit 38 that is configured to determine a drift of a characteristic of the signal received via the input 16 based on the parameters/settings.

The monitoring system 10 also comprises an adjustment sub-circuit 40 that is configured to perform adjustments due to the drift detected. The respective adjustments are also based on parameters/settings.

Moreover, the monitoring system 10 has an output interface 42, for instance an internal output interface and/or an external output interface, via which information about the adjustments made can be forwarded to another circuit or module 44, for instance an internal circuit/module like an analysis circuit and/or an external module/device.

Generally, the monitoring system 10 shown in Figure 1 is configured to perform a method of monitoring a signal with inherent periodic characteristics, a flow-chart of which is shown in Figure 2 to which reference is made hereinafter.

At the beginning, the settings/parameters for the method are defined, which may be done in a random order if applicable, e.g. different to the order shown. Afterwards, the measurement takes place based on which the monitoring of the signal is done. However, at least some of the settings/parameters may be also be set during the measurement. Again, the respective order illustrated in Figure 2 is not mandatory, but an exemplarily order.

In a first step S1, a monitoring time period for the signal with the inherent periodic characteristics is set. The monitoring time period may be set to match a frame structure of the signal to be monitored, e.g. 10 ms for a 5G TDD signal.

In a second step, a monitoring window may be set wherein a length and an offset to a start point of the monitoring time period for the monitoring window is defined.

Actually, the monitoring window may defined such that the monitoring window is aligned with a signal portion of interest that has been identified previously in a trace of the signal which was measured/captured within the monitoring time period based on the internal clock 32.

In a third step S3, at least one reference mark is identified in the respective trace measured/captured as well.

The reference mark may be identified manually by a user, for instance via the (graphical) user interface 36, or automatically by scanning the signal with the inherent periodic characteristics and detecting a repeated appearance of a transition in the signal with the inherent periodic characteristics. The automatic identification may be done by the at least one processing circuit 18 of the measurement system 10.

Generally, the reference mark may relate to a characteristic of the signal, for instance a high-to-low appearance or rather a low-to-high appearance.

In a fourth step S4, an initial reference mark offset is calculated with respect to the monitoring time period set previously.

Once the respective settings are done, the monitoring of the signal with inherent periodic characteristics can be performed, wherein the monitoring window used may be aligned if necessary, particularly in an automatic manner.

As shown in Figure 2, the monitoring and aligning may be done in a repetitive manner due to the repetitive characteristics of the signal with inherent periodic characteristics.

Accordingly, the monitoring and aligning step S5 comprises several sub-steps which at least partly are periodically repeated, namely for each new monitoring time period.

In step S5-1, a new periodic (video) trace may be obtained from the period trace generation sub-circuit 34 that has segmented the (video) trace obtained from the trace sub-circuit 30 depending on the parameters/settings, namely the monitoring time period. This may be done during the continuously measuring of the trace of the signal.

In step S5-2, the position of the at least one reference mark identified previously is detected while a drift of the reference mark might be detected in case it occurs. This is done based on the initial reference mark offset calculated previously. Actually, the difference of the current position of the reference mark and the initial reference mark offset is calculated in order to detect the drift of the reference mark.

In step S5-3, the respective drift detected is compared with a (pre-defined) threshold value. Hence, it is determined whether the drift detected exceeds the threshold value or not. In case the threshold value is not exceeded, no further action is required, as it is assumed that the monitoring window is still aligned with the signal portion of interest, as shown in Figure 2. A new periodic (video) trace is obtained from the period trace generation sub-circuit 34 for further processing.

In case the threshold value is exceeded, it is assumed that the monitoring window is not aligned with the signal portion of interest anymore. Consequently, the monitoring window is adjusted in step S5-4.

The adjustment of the monitoring window can be done by changing the offset to the start point of the monitoring time period and/or by changing the length of the monitoring window.

Optionally, the monitoring time period may be adjusted as well. Particularly, the monitoring time period is only adjusted in case a further threshold value is exceeded, which is indicative of a high drift.

Once the monitoring window has been adjusted, the reference mark offset used for determining whether a drift occurred is adjusted as well in step S5-5. In fact, the adjusted reference mark offset is used as a new setting.

Afterwards, A new periodic (video) trace is obtained from the period trace generation sub-circuit 34 for further processing.

Consequently, a drift of the signal received can be determined without the need of a time synchronization to a highly accurate external time source like a GNSS time source or by decoding the signals used, e.g. being part of the network. In fact, the drift can be determined by relying on the reference mark within the signal to be monitored and using the internal clock 32. It is assumed that a drift of the reference mark is similar to the drift of the signal portion of interest such that synchronizing the monitoring window in accordance with the drift detected simultaneously aligns the monitoring window with the signal portion of interest.

Therefore, a cost-efficient and reliable method is provided for monitoring signals with inherent periodic characteristics like TDD signals.

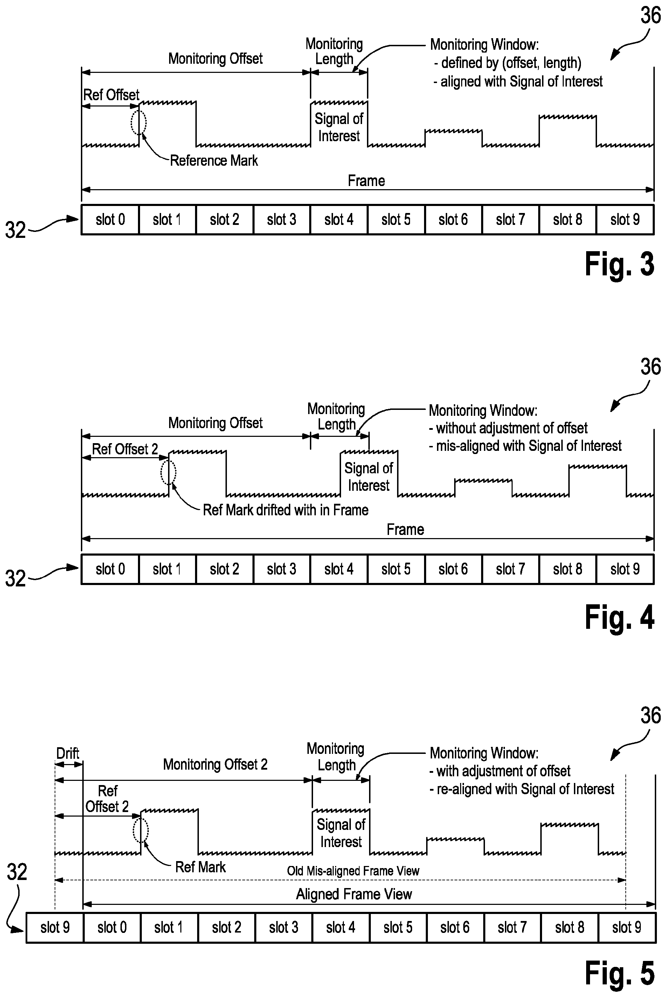

In Figures 3 to 5, the consequences of the method are illustrated accordingly.

As shown in Figure 3, the signal with the inherent periodic characteristics is shown, wherein a 5G TDD signal is used as an example, which has a frame length of 10 ms and ten sub-frames associated with slots 0 to 9. The respective time reference is an internal time reference, namely the one provided the internal clock 32.

Accordingly, the monitoring time period is set to 10 ms so as to match the frame structure of the signal.

The trace of the signal is measured continuously within the monitoring time period based on the internal clock 32, namely the internal time reference. The trace may be displayed on the (graphical) user interface 36.

A signal portion of interest is identified in the trace, for instance via the (graphical) user interface 36.

Based thereon, namely based on the monitoring time period set, e.g. the frame structure of the signal, and the signal portion of interest identified, the settings/parameters for the monitoring window may be defined, namely the length of the monitoring window and an offset to a start point of the monitoring time period. The monitoring window is defined such that the monitoring window is aligned with the signal portion of interest. This can be done automatically based on the parameters/settings mentioned above.

In addition, at least one reference mark is identified in the trace, for instance a low-to-high transition/appearance in the signal to be monitored, wherein the initial reference mark offset to the monitoring time period is calculated, namely the beginning of the monitoring time period.

Generally, two or more reference marks may be identified, for instance a low-to-high transition/appearance in the signal to be monitored as well as a high-to-low transition/appearance in the signal to be monitored.

Hence, all settings/parameters are done for the continuous monitoring of the signal and the alignment of the monitoring window if necessary.

In Figure 4, it is shown that a drift occurs (Ref Offset 2 is larger than Ref Offset shown in Figure 3) and the method according to the invention as shown in Figure 2 is not applied. Actually, the drift may occur as the internal clock 32 is not synchronized with a transmitter of the signal to be monitored, namely a highly accurate global time source.

Consequently, the monitoring window is not aligned with the signal portion of interest anymore.

In Figure 5, the same situation is shown, but the method according to the invention as shown in Figure 2 is applied.

Accordingly, drift of the reference mark ("Drift") is detected and calculated as described above, wherein it was determined that the drift exceeds the threshold value.

Therefore, the monitoring window was adjusted such that the monitoring window is aligned again with the signal portion of interest in the trace. As discussed above, the offset and/or the length of the monitoring window may be changed for adjusting the monitoring window.

Optionally and if necessary, the monitoring time period may be adjusted as well, which however is not shown in Figure 5, as the drift is a relatively small one.

In Figure 5, it is also shown that the drift detected causes a re-alignment of the internal time reference, as the frame view is adjusted as well.

As already indicated above, the information about the adjusted monitoring window may be forwarded to the output interface 42 such that other circuits/modules/devices may be informed accordingly, for instance analysis circuits/modules/devices.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A method of monitoring a signal with inherent periodic characteristics, wherein the method comprises the steps of:
- Setting a monitoring time period for the signal,
- Measuring a trace of the signal continuously within the monitoring time period based on an internal clock,
- Identifying a signal portion of interest in the trace,
- Defining a length and an offset to a start point of the monitoring time period for a monitoring window such that the monitoring window is aligned with the signal portion of interest,
- Identifying at least one reference mark in the trace,
- Detecting a drift of the reference mark while monitoring the signal,
- Determining whether the drift detected exceeds a threshold value, and
- Adjusting the monitoring window in case the drift detected exceeds the threshold value.

2. The method according to claim 1, wherein the monitoring window is adjusted by changing the offset and/or the length of the monitoring window.

3. The method according to claim 1 or 2, wherein the monitoring window is adjusted such that the monitoring window is aligned again with the signal portion of interest in the trace even though the drift occurred.

4. The method according to any one of the preceding claims, wherein information about the adjusted monitoring window is forwarded to an output interface (42).

5. The method according to any one of the preceding claims, wherein the monitoring time period is adjusted.

6. The method according to any one of the preceding claims, wherein the monitoring time period is set to match a frame structure of the signal.

7. The method according to any one of the preceding claims, wherein the reference mark is identified manually by a user.

8. The method according to claim 7, wherein the reference mark is identified by setting the reference mark in the trace via a user interface (36).

9. The method according to any one of the preceding claims, wherein the reference mark is identified automatically by scanning the signal and detecting a repeated appearance of a transition in the signal.

10. The method according to any one of the preceding claims, wherein the at least one reference mark relates to a characteristic of the signal.

11. A monitoring system (10) for monitoring a signal with inherent periodic characteristics, wherein the monitoring system (10) comprises an input (16) configured to receive the signal, wherein the monitoring system (10) comprises at least one processing circuit (18) that is connected with the input (16), and wherein the at least one processing circuit (18) is configured to continuously measure a trace of the signal received within a monitoring time period based on an internal clock, to define a length and an offset to a start point of the monitoring time period for a monitoring window such that the monitoring window is aligned with a signal portion of interest in the trace, to detect a drift of a reference mark identified while monitoring the signal, to determine whether the drift detected exceeds a threshold value, and to adjust the monitoring window in case the drift detected exceeds the threshold value.

12. The monitoring system (10) according to claim 11, wherein the at least one processing circuit (18) is configured to adjust the monitoring window by changing the offset and/or the length of the monitoring window.

13. The monitoring system (10) according to claim 11 or 12, wherein the monitoring system (10) comprises a user interface (36) via which a user is enabled to set the monitoring time period, to identify the signal portion of interest in the trace, and/or to identify the at least one reference mark in the trace.

14. The monitoring system (10) according to any one of claims 11 to 13, wherein the at least one processing circuit (18) is configured to automatically identify the at least one reference mark in the trace based on a repeated appearance of a transition in the signal.

15. The monitoring system (10) according to any one of claims 11 to 14, wherein the monitoring system (10) comprises an output interface (42) via which information about the adjusted monitoring window is outputted.

## Amended claims

### Amended claims in accordance with Rule 137(2) EPC.

1. A method of monitoring a signal with inherent periodic characteristics by means of a monitoring system (10), wherein the method comprises the steps of:
- Setting a monitoring time period for the signal,
- Measuring a trace of the signal continuously within the monitoring time period based on an internal clock,
- Identifying a signal portion of interest in the trace,
- Defining a length and an offset to a start point of the monitoring time period for a monitoring window such that the monitoring window is aligned with the signal portion of interest,
- Identifying at least one reference mark in the trace,
wherein the method is **characterized by** the steps of:
- Detecting a drift of the reference mark while monitoring the signal,
- Determining whether the drift detected exceeds a threshold value, and
- Adjusting the monitoring window in case the drift detected exceeds the threshold value.

2. The method according to claim 1, wherein the monitoring window is adjusted by changing the offset and/or the length of the monitoring window.

3. The method according to claim 1 or 2, wherein the monitoring window is adjusted such that the monitoring window is aligned again with the signal portion of interest in the trace even though the drift occurred.

4. The method according to any one of the preceding claims, wherein information about the adjusted monitoring window is forwarded to an output interface (42).

5. The method according to any one of the preceding claims, wherein the monitoring time period is adjusted.

6. The method according to any one of the preceding claims, wherein the monitoring time period is set to match a frame structure of the signal.

7. The method according to any one of the preceding claims, wherein the reference mark is identified manually by a user.

8. The method according to claim 7, wherein the reference mark is identified by setting the reference mark in the trace via a user interface (36).

9. The method according to any one of the preceding claims, wherein the reference mark is identified automatically by scanning the signal and detecting a repeated appearance of a transition in the signal.

10. The method according to any one of the preceding claims, wherein the at least one reference mark relates to a characteristic of the signal.

11. A monitoring system (10) for monitoring a signal with inherent periodic characteristics, wherein the monitoring system (10) comprises an input (16) configured to receive the signal, wherein the monitoring system (10) comprises at least one processing circuit (18) that is connected with the input (16), and wherein the at least one processing circuit (18) is configured to continuously measure a trace of the signal received within a monitoring time period based on an internal clock, to define a length and an offset to a start point of the monitoring time period for a monitoring window such that the monitoring window is aligned with a signal portion of interest in the trace, **characterized in that** the at least one processing circuit (18) is configured to detect a drift of a reference mark identified while monitoring the signal, to determine whether the drift detected exceeds a threshold value, and to adjust the monitoring window in case the drift detected exceeds the threshold value.

12. The monitoring system (10) according to claim 11, wherein the at least one processing circuit (18) is configured to adjust the monitoring window by changing the offset and/or the length of the monitoring window.

13. The monitoring system (10) according to claim 11 or 12, wherein the monitoring system (10) comprises a user interface (36) via which a user is enabled to set the monitoring time period, to identify the signal portion of interest in the trace, and/or to identify the at least one reference mark in the trace.

14. The monitoring system (10) according to any one of claims 11 to 13, wherein the at least one processing circuit (18) is configured to automatically identify the at least one reference mark in the trace based on a repeated appearance of a transition in the signal.

15. The monitoring system (10) according to any one of claims 11 to 14, wherein the monitoring system (10) comprises an output interface (42) via which information about the adjusted monitoring window is outputted.
